Europäisches Patentamt

European Patent Office

Office européen des brevets

(11) Publication number: **0 069 102**
**B1**

# (12) EUROPEAN PATENT SPECIFICATION

(45) Date of publication of patent specification: **12.03.86**

(21) Application number: **82850145.2**

(22) Date of filing: **24.06.82**

(51) Int. Cl.⁴: **H 01 P 5/08, H 01 P 3/08**

(54) Impedance matching stripline transition for microwave signals.

(30) Priority: **30.06.81 SE 8104097**

(43) Date of publication of application:
**05.01.83 Bulletin 83/01**

(45) Publication of the grant of the patent:
**12.03.86 Bulletin 86/11**

(84) Designated Contracting States:
**CH DE FR GB IT LI NL**

(56) References cited:
**US-A-3 303 439**
**US-A-3 533 023**
**US-A-3 757 272**

**RADIO FERNSEHEN ELECTRONIK, vol. 28, no. 8, August 1979, pages 500-502, Berlin (GDR); G. TURINSKY: "Angepasste Wellenleitungen in Mehrebenenleiterplatten"**

**G.RAGAN: "Microwave transmission circuits", 1948, 1st Edition, McGRAW-HILL Book Company, Inc., New York (USA);**

(73) Proprietor: **TELEFONAKTIEBOLAGET L M ERICSSON**
**S-126 25 Stockholm (SE)**

(72) Inventor: **Josefsson, Lars Gustaf**
**Gäsmossen 41**
**S-436 00 Askim (SE)**
Inventor: **Svensson, Bengt Tomas**
**Hökegardsgatan 11B**
**S-431 38 Mölndal (SE)**
Inventor: **Moeschlin, Lars Felix**
**Södra Fiskebäcksvägen 84**
**S-421 58 V.Frölunda (SE)**

(74) Representative: **Wennerholm, Kristian et al**
**TELEFONAKTIEBOLAGET L M ERICSSON**
**S-126 25 Stockholm (SE)**

Courier Press, Leamington Spa, England.

## Description

### Technical Field

The present invention relates to an impedance matching stripline transition for microwave signals which from a stripline circuit on a first laminate should lead to a stripline circuit on second laminate through a number of intermediate laminates.

### Background Art

In the microwave technique sometimes so called stripline circuits are used instead of wave guides to conduct microwave signals. Such circuits consists of thin tapes or strips of conducting material, etched on laminates of dielectric material. An applicable area is in producing microwave antennas, described, for example, in the US—Patent 4.150.383. Such an antenna consists of dielectric slabs with the antenna elements performed as stripline circuits.

A multilayered circuitry interconnection including a plurality of striplines is shown in US—A—3.533.023. This circuitry aims to connect electronic components, for example microwave transistors by means of signal conductor patterns including separate conductors formed and sandwiched on insulating layers which in turn are sandwiched between ground planes. The signal conductors run horizontally and along between two laminates from one electronic component to another component inbedded in the structure. A coaxial like transition between an upper laminate and a lower laminate is also shown which consists of an electrical device in the form of a wire as a central conductor and a number of rod-shaped ground conductors as shielding members. The shielding members are disposed around each of the components. This known structure, however, implies a complicated structure due to the number of loose parts (insulating washers, rods and wire).

In US—A—3.757.272 a strip transmission coupler arrangement is shown which shows a mechanical coupling device and a center conductor pin in order to obtain conductive connection between the center strip conductors. This known arrangement has for purpose to connect two center strip conductors on different laminates or to connect a center strip conductor to a coaxial-type transmission line.

### Disclosure of Invention

In antennas with stripline circuits of the above mentioned kind, the problem arises of impedance matching a stripline circuit on a dielectric slab to a stripline circuit on another slab. The two slabs need not necessarily be located close to each other but a connection is needed, for example, between the outermost of the slabs in the antenna, a transition then must be provided, passing the intermediate slabs. A possibility would be to provide a connection in the form of a coaxial cable passing the intermediate slabs and connect the terminals of the coaxial cable to the two stripline circuits. Such a connection will be relatively clumsy and, in addition, problems with the transition coax-stripline circuit will arise.

According to the invention said problem will be solved by a coaxial-like transition on the slabs as through-plated holes, forming on the one hand a main conductor and on the other an outer conductor (screen) for the microwave signals. In that way a simple connection between the stripline circuits are obtained without any separate coaxial connection and belonging transitions. The transition according to the invention is characterized as it appears from the characterizing part of the claim 1.

### Brief Description of Drawing

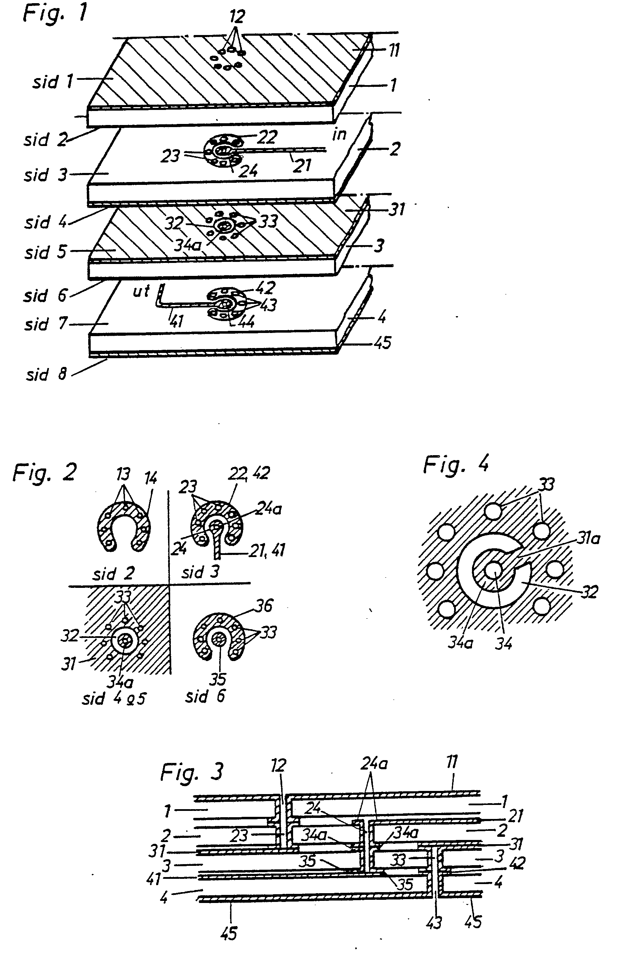

The invention will be described more in detail with reference to the accompanying drawing where Figure 1 shows a perspective view of four laminate slabs on which the transition according to the invention is provided; Figure 2 shows more closely the transition on various sides of the laminate according to Figure 1; Figure 3 shows the transition according to Figure 1 in cross section; Figure 4 shows an impedance matching on one of the sides according to Figure 2.

### Mode for Carrying Out the Invention

The basic point for a stripline transition according to the invention is, for example, four laminate slabs 1, 2, 3 and 4 coated on all sides with copper according to Figure 1. The laminate slab 1 is on the shown upper side coated with a layer 11 of conducting material, for example copper. Through the slab there is a number of holes 12, which are through-plated and on the underside of the laminate 1 a horseshoe-shaped structure 14 of a conducting material (copper) has been formed. On the second laminate 2 a stripline circuit has been formed in known way, the conductor 21 of which forms an input conductor to the lead-through. The conductor 21 is terminated by a through-plated hole 24 and around the collar 24a of the hole a horseshoe-shaped structure 22 is formed, like the underside of the laminate 1 (side 2 according to Figure 2), with through-plated holes 23 (Figure 1). The upper side of the laminate 2 is in Figure 2 denoted by side 3 and its underside (in Figure 1 not shown) is denoted side 4. On side 4 (laminate 2) the through-plated hole 24 ends in a collar 34a which along an open area 32 limited by the circular formed edge of the layer 31 lies isolated from the through-plated holes 33, constituting the continuation of the holes 12 (laminate 1) and 23 (laminate 2). The side 4 (laminate 2) is for the rest copper-coated like the upper side (side 5) of the laminate 3 and consists a common earth plane for the stripline transition. On the upper side of the laminate 4 (side 7 in Figure 2) a stripline circuit, in this embodiment not shown in detail, is arranged whose connecting conductor to the transition is denoted by 41. The conductor 41 is terminated by a collar 44 to fit the collar 34a on the underside (side 5) of the laminate 3. A horseshoe-shaped structure 42 is formed on the upper side of the laminate 4 (side 7) and shows through-plated holes 43 through the laminate 4 to the copper-coated underside 45 (side 8) of the laminate. In this shown embodiment the opening of the horseshoe-shaped structure of the holes 12, 23 and the copper surfaces 14, 22 is turned to the right in Figure 1, while the opening of the corresponding structure holes 33, and the surfaces 36, 42 is turned to the left in Figure 1.

The connection between the two layers of stripline circuits on the upper side (side 3) of the laminate 2 and the upper side (side 7) of the laminate 4 is thus in principle performed as a short coaxial line. The outer conductor of the coaxial line is formed by a number of through-plated holes 12, 13, 23, 33, 43 in close circular form (in Figures 1, 2 horseshoe-shaped) around a center conductor also consisting of through-plated holes 24, 34. The outer conductor is connected to the earth planes 31, 11 and 45 of the laminates 1—4. At the same time it serves as a suppressor of undesired modes in the microwave signals fed to the transition via the conductor 21.

In Figure 3 the stripline transition according to Figure 1 is shown in cross section while maintaining the same reference numbers. On the two laminates 2 and 4 the stripline layers are assembled to a complete multilayer unit, where contact between the through-plated holes of the layers has been attained by that a collar, for example 24a, which indicates a hole in the centre conductor, has been pressed towards a corresponding collar 34a in the subsequent layer. The same is valid for the outer conductor where, for example, the horseshoe-shaped section 14 has been pressed towards 22, the section 42 towards the section 36 etc, so that the holes form a transition through the laminates. The plated holes are performed in a layer each, in order to obtain the highest possible flexibility in the construction. The laminate slabs are kept together, for example by gluing.

The construction makes it possible that a great number of circuits can be integrated into one unit, jointed as described above, by through-plated holes. It is characteristic that the holes are not plated through the whole structure (as in ordinary multilayer technique for printed circuits) but give space for other circuits in the layers where the holes thus are not necessary to be introduced.

For impedance matching of a transition, compensating reactances can be introduced in connecting stripline circuits. In the present construction, however, this can be made in a simple way by an inductive matching in the coaxial structure. No extra space is required for this. Figure 4 shows the lead-through according to Figure 1 from the underside of the laminate 2 ("side 4"). From the collar 34a there is a stud 31a between the collar and the earth plane 31 which bridges the isolated area 32 and which gives the inductive matching in the coaxial structure.

**Claims**

1. An impedance matching coaxial transition for microwave signals having an input conductor from a stripline circuit on a first laminate (2) and an output conductor to a stripline circuit on a second laminate (4), a number of intermediate laminates (3) being situated between the first and the second laminate (2, 4) which together form a stack of laminates, a number of through-holes being provided through the stack characterized in that said holes (24, 34) are through-plated for each of said laminates and each provided with conducting collars (24a, 34a) on both side of each laminate including a slightly elevated area above the laminate area so that said collars (24a, 34a) make electrical contact between said holes (24, 34) on each of said laminates (2, 3, 4) and so that the input conductor (21) is conductively connected with the output conductor (41), thus forming the coaxial center conductor and that further through-plated holes (12, 23, 33, 43) forming the coaxial return conductor or shield are provided close to said through-plated holes (24, 34) forming the center conductor and provided with conducting areas around said further holes (12, 23, 33, 43) and on the laminate to make conducting connection between said further through-plated holes and with a reference potential (ground).

2. An impedance matching coaxial transition according to claim 1, characterized in that said further through-plated holes on a laminate (2, 4) is conductively connected by means of a circle like formed metallic layer (22, 42) around the through-plated holes (24, 34).

3. An impedance matching coaxial transition according to claim 1, characterized in that an intermediate laminate (3) on one surface is provided with a conducting layer (31) which extends across said further through-plated holes (33) to conductively connect these and to an isolating area (32) which isolates the layer (31) from the through-plated holes (24, 34) which connect the input and the output conductor (21, 41, respectively).

4. An impedance matching coaxial transition according to claim 3, characterized in that the isolated area (32) is bridged by means of a stud (31a) for inductive match in the coaxial structure.

**Patentansprüche**

1. Widerstandsangepaßter Koaxialübergang für Mikrowellensignale mit einem Eingangsleiter von einer Bandleitungsschaltung auf einem ersten Laminat (2) und einem Ausgangsleiter zu einer Bandleitungsschaltung auf einem zweiten Laminat (4), wobei eine Anzahl von Zwischenlaminaten (3) zwischen dem ersten und zweiten Laminat (2, 4) angeordnet ist, die zusammen einen Stapel von Laminaten bilden, wobei eine Anzahl von Durchgangslöcher im Stapel vorgesehen sind, dadurch gekennzeichnet, daß die Löcher (24, 34) in jedem der Laminate durchplattiert sind und jedes mit leitenden Ringen bzw.

Kragen (24a, 34a) auf beiden Seiten jedes Laminates versehen ist, umfassend eine leicht angehobene Fläche oberhalb der Laminatfläche, so daß diese Kragen oder Ringe (24a, 34a) elektrischen Kontakt zwischen den Löchern (24, 34) auf jedem der Laminate (2, 3, 4) geben, und daß der Eingangsleiter (21) leitend mit dem Ausgangsleiter (41) verbunden ist und so den koaxialen Mittenleiter bildet, und daß außerdem durchplattierte Löcher (12, 23, 33, 43) den koaxialen Rück-Leiter oder eine Abschirmung bilden und dicht zu den durchplattierten Löchern (24, 34) angeordnet sind, die den Mittenleiter bilden und mit leitenden Flächen rund um die weiteren Löcher (12, 23, 33, 43) versehen sind sowie auf dem Laminat, um die leitende Verbindung zwischen den weiteren durch-plattierten Löchern und einem Referenzpotential (Masse) zu schaffen.

2. Widerstandsangepaßter Koaxialübergang nach Anspruch 1, dadurch gekennzeichnet, daß die weiteren durch-plattierten Löcher eines Laminates (2, 4) leitend verbunden ist durch eine kreisähnlich gebildete metallische Schicht (22, 42) rund um die durchgehende beschichteten Löcher (24, 34).

3. Widerstandsangepaßter Koaxialübergang nach Anspruch 1, dadurch gekennzeichnet, daß ein Zwischenlaminat (3) auf einer Oberfläche mit einer leitenden Schicht (31) versehen ist, welche sich quer über die weiteren durch-plattierten Löcher (33) erstreckt, um diese leitend zu verbinden und zu einer isolierenden Fläche (32), welche die Schicht (31) von den durchplattierten Löchern (24, 34) isoliert, welche den Eingang und den Ausgangsleiter (jeweils 21, 41) verbinden.

4. Widerstandsangepaßter Koaxialübergang nach Anspruch 3, dadurch gekennzeichnet, daß die isolierte Fläche (32) durch eine Verbindungsbrücke (31a) überbrückt ist für eine induktive Anpassung in der koaxialen Struktur.

**Revendications**

1. Une transition coaxiale d'adaptation d'impédance pour des signaux hyperfréquences, comportant un conducteur d'entrée qui provient d'un circuit à ligne en bande sur une première plaquette (2), et un conducteur de sortie dirigé vers un circuit à ligne en bande sur une seconde plaquette (4), avec un certain nombre de plaquettes intermédiaires (3) intercalées entre les première et seconde plaquettes (2, 4), de façon à former ensemble un empilement de plaquettes, avec un certain nombre de trous traversant l'empilement, caractérisée en ce que ces trous (24, 34) sont métallisés pour chacune des plaquettes et chacun d'eux comporte des collets conducteurs (24a, 34a) sur les deux faces de chaque plaquette, comprenant une zone légèrement surélevée par rapport à la surface de la plaquette, de façon que ces collets (24a, 34a) établissent un contact électrique entre les trous (24, 34) sur chacune des plaquettes (2, 3, 4), et de façon que le conducteur d'entrée (21) soit connecté de façon conductrice au conducteur de sortie (41), et forme ainsi le conducteur central coaxial, et en ce que des trous métallisés supplémentaires (12, 23, 33, 44) formant le conducteur coaxial de retour ou le blindage sont formés à proximité des trous métallisés (24, 34) formant le conducteur central, avec des zones conductrices formées autour des trous supplémentaires (12, 23, 33, 43) et sur la plaquette, pour établir une connexion conductrice entre ces trous métallisés supplémentaires et un potentiel de référence (masse).

2. Une transition coaxiale d'adaptation d'impédance selon la revendication 1, caractérisée en ce que les trous métallisés supplémentaires formés sur une plaquette (2, 4) sont connectés de façon conductrice au moyen d'une couche métallique (22, 42) formée en forme de cercle autour des trous métallisés (24, 34).

3. Une transition coaxiale d'adaptation d'impédance selon la revendication 1, caractérisée en ce qu'une plaquette intermédiare (3) comporte sur une surface une couche conductrice (31) qui s'étend transversalement aux trous métallisés supplémentaires (33), pour connecter ceux-ci de façon conductrice, et qui s'étend jusqu'à une zone d'isolation (32) qui isole la couche (31) des trous métallisés (24, 34) qui connectent les conducteurs d'entrée et de sortie (respectivement 21, 41).

4. Une transition coaxiale d'adaptation d'impédance selon la revendication 3, caractérisée en ce que la zone isolée (32) est traversée par un élément conducteur (31a) de façon à réaliser une adaptation inductive dans la structure coaxiale.

0 069 102

Fig. 1

Fig. 2

Fig. 4

Fig. 3